# EUROPEAN PATENT APPLICATION

(11) **EP 1 115 159 A1**
(43) Date of publication of application: **11.07.2001**
(21) Application number: 98941778.7
(22) Date of filing: 09.09.1998
(51) Int. Cl.: H01L 29/80, H02M 1/08

(54) **STATIC INDUCTION TRANSISTOR AND ITS MANUFACTURING METHOD, AND POWER CONVERTER**

(71) Applicant: Hitachi, Ltd., Chiyoda-ku, Tokyo 101-8010 (JP)
(72) Inventor: IWASAKI, Takayuki, Hitachi Res. Lab., Hitachi Ltd, Hitachi-shi, Ibaraki 319-1221 (JP); YATSUO, Tsutomu, Hitachi Res. Lab., Hitachi Ltd, Hitachi-shi, Ibaraki 319-1221 (JP); ONOSE, Hidekatsu, Hitachi Res. Lab., Hitachi Ltd, Hitachi-shi, Ibaraki319-1221 (JP); OONO, Toshiyuki, Hitachi Res. Lab., Hitachi Ltd, Hitachi-shi, Ibaraki 319-1221 (JP)
(74) Representative: Beetz & Partner Patentanwälte
(86) International application number: JP9804039
(87) International publication number: WO0014809

(57) **Abstract**

A static induction transistor according to the invention comprises a semiconductor substrate with an energy band gap greater than that of silicon, and the semiconductor substrate has a first gate region to which a gate electrode is connected, and a second gate region positioned within a first semiconductor region which becomes a drain region, and the first gate region is in contact with a second semiconductor region which becomes a source region. According to the invention, the OFF characteristics of the static induction transistor are improved.

## Description

### Technical Field

The present invention relates to a static induction transistor.

### Background Art

As electric power converters are requested to be of large power and high frequency, a semiconductor switching element is requested not only to have a large controllable . current but also to be of low loss and operated at high speeds.

In order to respond such request, switching elements with constituent element of SiC (silicon carbide) have been proposed. For example, a power MOSFET has been studied as disclosed in IEEE Electron Devices Letters, Vol. 18, No. 3, p. 93-95 (1997), "High-Voltage Double-Implanted Power MOSFET's in 6H-SiC". However, since an inversion layer with low carrier mobility is used for a channel layer being a current passage, a problem exists in that the ON voltage becomes high.

In order to avoid this problem, there is a static induction transistor where an inversion layer is not used as a channel layer (disclosed in, for example, IEEE Trans. on Electron Devices, Vol. ED-22, p. 185-197, 1975, "Field-effect Transistor versus Analog Transistor (Static Induction Transistor)).

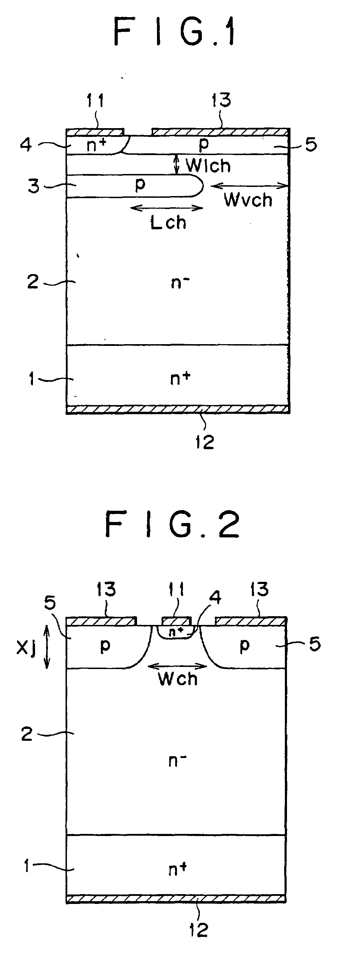

Fig. 2 is a sectional view of a static induction transistor in the prior art. The semiconductor substrate comprises an n⁺-type region 1, an n⁻-type region 2 and a p-type region 5, and a source electrode 11, a drain electrode 12 and a gate electrode 13 are provided. Potential of the gate is made lower than that of the source, whereby a depletion layer is extended to a region provided by the p-type region 5, so-called channel region, and a current flowing through the drain electrode 12 and the source electrode 11 can be turned off. Since the substrate of SiC is used for the channel region, quite low ON-resistance can be realized. This is reported, for example, in International Conference on Silicon Carbide, III-nitrides and Related Materials-1997, Abstract p. 443 (1997), "Electrical Characteristics of A Novel Gate Structure 4H-SiC Power Static Induction Transistor".

In the basic structure in Fig. 2, however, a problem exists in that the OFF characteristics are considerably bad. That is, in order to turn a current off, a layer gate voltage must be applied. This is caused by that the impurity diffusion coefficient of SiC is small. In silicon, when a deep p-type region is to be formed, thermal diffusion is used, but in SiC, this process can not be applied. As a result, a local p-type region such as a p-type region 5 is formed by ion implantation, but even if boron with relatively small atomic weight is implanted in energy of about 2 Mev called high energy implantation, the depth is about 2 µm at most. The implantation of higher energy can make the junction deep, but a defect may remain which can not be removed by the heat treatment afterward. As a result, a leak current increases and the OFF characteristics become bad.

Also when the ion implantation of high energy is partially performed, it is difficult to form an implantation mask withstanding this state.

In Fig. 2, Xj is called channel length, and Wch is called channel width. In place of increasing Xj, means for decreasing the channel width Wch may be taken into consideration. In this case, however, Wch must be atomized significantly. Therefore a problem exists in that the ON characteristics are significantly deteriorated.

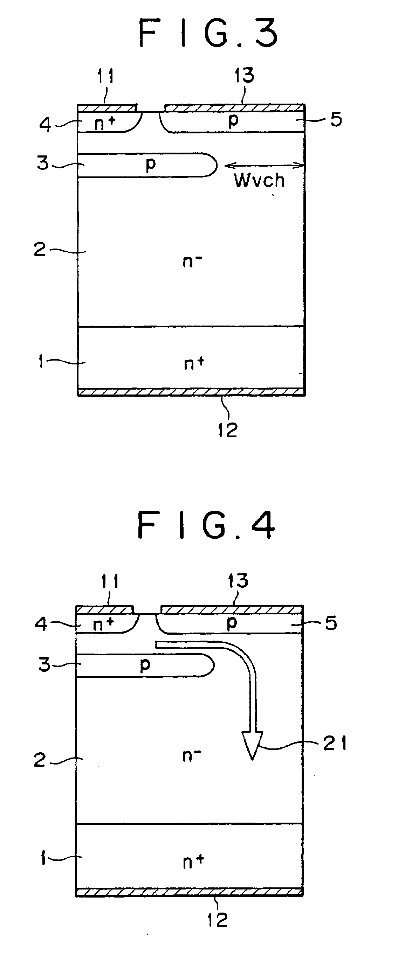

In order to solve the above-mentioned problems, a structure is proposed under idea that a gate is constituted by a surface p-type region and an embedded p-type region and a channel is laid in the lateral direction. For example, Japanese Patent Laid-open 59-150474 discloses a specific application example of a static induction thyristor. Fig. 3 is a sectional view of a static induction transostor of SiC based on the proposal. The semiconductor substrate comprises an n⁺-type region 1, an n⁻ -type region 2 and a p-type region 5, and a source electrode 11, a drain electrode 12 and a gate electrode 13 are provided. In this example, an n⁺-type source region 4 and a first gate region 5 of p type are provided on one main surface of the semiconductor substrate, and a second gate region 3 comprising a p-type embedded layer including projection parts of the n⁺-type source region 4 and the n⁺-type source region 5 is formed at a position deeper than both regions 4, 5. The second gate region 3 has a vacant longitudinal channel portion Wvch within a surface in parallel to the main surface. When the second gate region 3 has the same potential as the first gate region 5 and negative potential with respect to the source electrode 11 is applied to the gate electrode 13, a current between the source and the drain can be turned off.

Difference in operation of this example from the previous example in the prior art shown in Fig. 2 will be explained as follows. Fig. 4 is a sectional view of the example in the prior art in Fig. 3 in the conduction state. In Fig. 4, numeral 21 designates flow of electrons. In this case, electrons injected from the source electrode 11 flow through the channel in the lateral direction. And then while turning the direction to the drain side, the electrons flow into the drain electrode 12. That is, the channel becomes the lateral direction. In this example, since the channel is in the lateral direction, the channel length is not limited by the ion implantation depth or the like, but can be adjusted freely by microfabrication technology such as photo etching. Further since the channel width can be adjusted by width of the epitaxial growth and the ion implantation energy in the case of forming the p-type gate region, a high control property can be obtained. According to this example in the prior art as above described, the SiC static induction transistor being excellent in the OFF characteristics can be expected without deteriorating the ON characteristics significantly.

In the example in the prior art shown in Fig. 3, however, a problem exists in that the pattern matching work with considerably high accuracy is required for the exact control of the channel length which strongly influences the pinch-off characteristics of the channel. That is, in the prior art using the conventional constituent material of Si, in order that the voltage of the junction between the gate and the source is made high, a part of the n⁻-type region 2 is interposed between the n⁺-type source region 4 and the first gate region 5. When the idea in the conventional case of Si is applied to the element using the constituent material of SiC as it is, necessary width for the n⁻-type region to be interposed becomes about 1 µm. Thus significantly high accuracy is required for the pattern matching when the n⁺-type region 4 and the first gate region 5 are formed. As a result, the manufacturing of the element having constant pinch-off characteristics becomes very difficult.

### Disclosure of Invention

A first object of the present invention is to provide a structure of a static induction transistor excellent in the OFF characteristics without deteriorating the ON characteristics.

Another object of the present invention is to provide a structure to enable manufacturing of the above-mentioned static induction transistor at a high yield factor and a method of manufacturing the same.

Another object of the present invention is to provide an electric power conversion apparatus of high performance using the above-mentioned static induction transistor.

In the static induction transistor according to the first invention, a semiconductor substrate having an energy band gap greater than that of silicon includes a first gate region of a second conduction type and a second gate region of a second conduction type positioned respectively at the surface and the inside of a first semiconductor region of a first conduction type serving as a drain region. The first gate region is positioned at the surface of the first semiconductor region and is in contact with a second semiconductor region of a first conduction type serving as a source region. According to the present invention, since the second semiconductor region and the first gate region are in contact with each other, high accuracy is not required for the alignment of pattern in the second semiconductor region and pattern in the first gate region. Further since the energy band gap of the semiconductor material for the semiconductor substrate is greater than that of silicon, high withstanding voltage can be obtained even if the second semiconductor region and the first gate region are in contact with each other. Consequently the OFF characteristics of the static induction transistor are improved.

In the static induction transistor according to the second invention, in a semiconductor substrate having an energy band gap greater than that of silicon, a first semiconductor layer of a first conduction type serving as a drain region and a gate electrode form a Schottky junction. Thus high gate withstanding voltage can be obtained. Further according to the present invention, since the pn junction is not used but the Schottky junction is used in the gate electrode part, there is no problem of alignment between semiconductor layer patterns when the high gate withstanding voltage is to be obtained.

The first conduction type and the second conduction type as above described are p type or n type respectively, and are in an opposite conduction type to each other.

In a method of manufacturing a static induction transistor according to the present invention, a gate region is formed by the epitaxial method. Consequently the static induction transistor having high gate withstanding voltage can be produced at a high yield factor.

In an electric power conversion apparatus according to the present invention, the static induction transistor according to the present invention as above described is turned on or off and thereby the electric power conversion is performed. Consequently the electric power conversion apparatus of high performance is provided.

### Brief Description of Drawings

Fig. 1 is a sectional view showing a first embodiment of a static induction transistor of SiC to which the invention is applied.

Fig. 2 is a sectional view showing an example of a static induction transistor in the prior art.

Fig. 3 is a sectional view showing another example of a static induction transistor in the prior art.

Fig. 4 is a sectional view showing flow of electrons in the conduction state of the static induction transistor in Fig. 2.

Fig. 5 is a sectional view showing a second embodiment of a static induction transistor of SiC to which the invention is applied.

Fig. 6 is a sectional view showing a third embodiment of a static induction transistor of SiC to which the invention is applied.

Fig. 7 is a sectional view showing a fourth embodiment of a static induction transistor of SiC to which the invention is applied.

Figs. 8A and 8B are views showing a more concrete embodiment of a static induction transistor of SiC to which the invention is applied.

Figs. 9A, 9B and 9C are diagrams of another embodiment of two-dimensional layout of unit cells.

Figs. 10A, 10B and 10C are diagrams of still another embodiment of two-dimensional layout of unit cells.

Figs. 11A, 11B and 11C are diagrams of an embodiment showing other coupling means of a gate region of unit cells.

Figs. 12A to 12D are sectional views showing a part of a characteristic fabricating process of the embodiment in Fig. 1.

Figs. 13A to 13D are sectional views showing a part of a characteristic fabricating process of the embodiment in Fig. 5.

Fig. 14 is a diagram showing a main circuit of an embodiment of an inverter device using a static induction transistor of SiC to which the invention is applied.

### Best Mode for Carrying Out the Invention

The present invention will be described in detail while disclosing embodiments as follows.

Fig. 1 is a sectional view showing a static induction transistor of SiC (silicon carbide) being a first embodiment of the present invention. A semiconductor substrate comprises an n⁺-type region 1, an n⁻-type region 2 being in contact with the n⁺-type region 1 and having an impurity concentration lower than that of the n⁺-type region 1, n⁺-type region 4 being in contact with the surface of the n⁻-type region 2 and having an impurity concentration higher than that of the n⁻-type region 2, and p-type region 5 serving as a first gate region. A source electrode 11, a drain electrode 12 and a gate electrode 13 are electrically connected to the n⁺-type region 4, the n⁺-type region 1 and the p-type region 5 respectively. The n⁻-type region is connected to the drain electrode 12 through the n⁺-type region 4, but the drain electrode may be in ohmic contact therewith directly. Further the n⁺-type region 4 and the p-type region 5 are provided at one main surface of the semiconductor substrate, and a second gate region 3 comprising a p-type embedded layer including projection parts of the n⁺-type region 4 and the p-type region 5 are formed at a deep position of both regions. The n⁻-type region 2 has a longitudinal channel part Wvch by which the second gate region 3 is lost within the plane in parallel to the main surface including the second gate region. Length Lch of an overlapping portion of respective projections of the first gate region 5 and the second gate region 3 with each other is made larger than the width Wlch of the n⁻-type region placed between the first gate region 5 and the second gate region 3, so that the depletion layer is easy to be pinched off between the first gate region and the second gate region when the negative potential is applied to the gate electrode 13.

The p-type region 3 is set at the floating state or the same potential as that of the n⁺-type region 4 or the same potential as that of the p-type region 5 being the gate region, and the negative potential with respect to the source electrode 11 is applied to the gate electrode 13. Thus a current flowing between the source electrode and the drain electrode can be turned off. Although not shown in this embodiment, a second gate electrode may be provided in the second gate region and a control signal may be given to the second gate electrode.

In this embodiment, since the semiconductor substrate is of SiC having the maximum breakdown electric field intensity about ten times as large as that of Si, high gate withstanding voltage of several tens V to several hundreds V can be obtained even if the n⁺-type region 4 and the p-type region 5 having a high impurity concentration are in contact with each other. Also when the n⁺-type region 4 and the p-type region 5 are formed, since patterns of both regions can be overlapped to be formed, the alignment accuracy can be reduced. That is, even in the low alignment accuracy, the gate withstanding voltage can be made without fail. In the static induction transistor, the reverse bias is applied to the junction between the gate and the source and the gate regions are mutually pinched off so that the voltage between the drain and the source can be blocked. Consequently for the element of high blocking voltage, the gate^{.}source junction having as high withstanding voltage as possible is required. As a result, according to this embodiment, the static induction transistor of high withstanding voltage can be obtained at a high manufacturing yield factor.

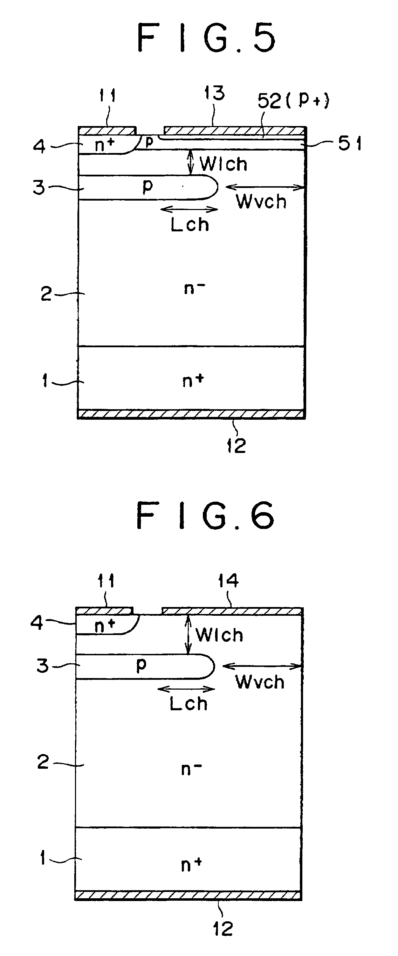

Fig. 5 shows a second embodiment of the present invention, which is a modification of the first embodiment. A first gate region is divided into a p-type part 51 having an impurity concentration higher than that of an n⁻-type region 2 being in contact with an n⁺-type region 4 but relatively low, and a p⁺-type region 52 being in contact with a gate electrode and having an impurity concentration higher than that of the p-type part 51. According to this embodiment, the gate·source junction in a high withstanding voltage and a low leak current can be formed, while holding the gate electrode connection in low resistance.

Fig. 6 is a sectional view of a static induction transistor of SiC, which is a third embodiment of the present invention. In this embodiment, on one main surface of the semiconductor substrate, a Schottky electrode 14 is provided to form a Schottky junction in an n⁻-type region 2. This constitution performs the same action as that of the first gate region 5 and the gate electrode 13 in the first embodiment as above described. In this embodiment, a high gate withstanding voltage can be obtained by the Schottky junction on the semiconductor surface of SiC. That is, a pn junction need not be formed on the surface of the semiconductor substrate in order to obtain the gate withstanding voltage. Consequently there is no problem of alignment to form the pn junction, and the static induction transistor of the high withstanding voltage can be manufactured at a high yield factor.

Also in this embodiment, the p-type region 3 is set at the floating state or the same potential as that of the n⁺-type source region 4 or the same potential as that of the gate electrode 14, and the negative potential with respect to the source electrode 11 is applied to the gate electrode 14. Thus a current flowing between the source and the drain can be turned off. Also in this embodiment, a second gate electrode may be provided in the second gate region 3 and a control signal may be given to the second gate electrode.

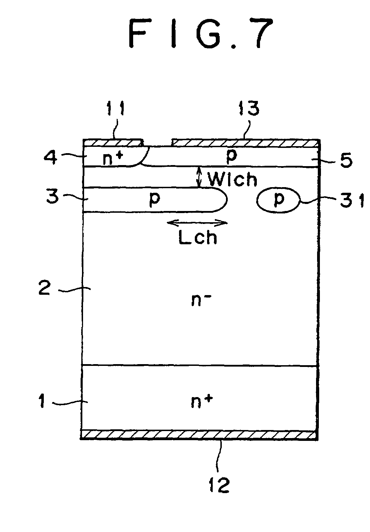

Fig. 7 shows a fourth embodiment of the present invention, which is another modification of the first embodiment. On a plane where a second gate region 3 is provided, there is a p⁺-type embedded region 31 at a position spaced apart from the second gate region. The region 31 is in the floating state electrically. When the voltage is blocked between the drain electrode and the source electrode, the region 31 has a function of facilitating the pinch-off between the first gate region and the second gate region, and provides the OFF characteristics of high withstanding voltage. This embodiment shows an example that the p⁺-type embedded region 31 is added to the first embodiment, but it may be added also to the second embodiment and the third embodiment. Although one p⁺-type embedded region is shown in this embodiment, two or more p⁺-type embedded regions may be provided.

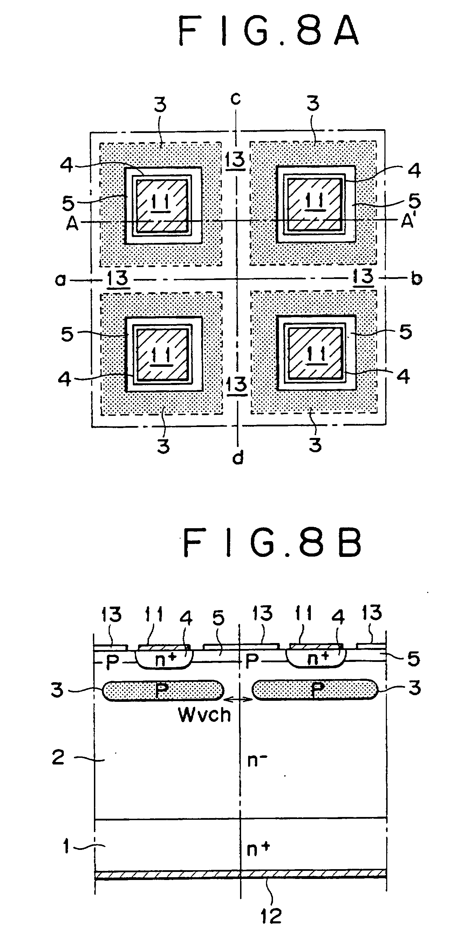

Any of the individual embodiments has been described based on the sectional structure of a unit cell of the semiconductor element. In more concrete structure, however, a plurality of cells are arranged within one semiconductor substrate. Figs. 8A and 8B show such an embodiment. Fig. 8A shows such arrangement that basic cells described in the first embodiment are arranged within the same basic body, and Fig. 8B is a sectional view in the position of the line AA' in Fig. 8A. Constituent parts in Figs. 8A and 8B designated by the same reference numerals as those in Fig. 1 indicate the parts equivalent in structure, conduction type and function. Although not shown in Figs. 8A and 8B, source electrodes 11 of individual cells are electrically connected to each other and the respective cells are connected so that they are operated in parallel within the semiconductor substrate. In Figs. 8A and 8B, only four cells are shown, but the number of cells can be increased in response to the current capacity of the semiconductor substrate. This embodiment shows an example that a unit cell is of square shape. However, the two-dimensional shape of the cell is not limited to square shape, but may be rectangular shape, square shape with rounded corners, polygonal shape or circular shape. In the case of a circular cell, however, in a portion where cells are arranged in cross (in Fig. 8A, a portion where lines ab and cd intersect orthogonally), the longitudinal channel part Wvch becomes wide. As a result, the pinch-off becomes insufficient and the voltage OFF characteristics of the high voltage may be deteriorated. Consequently the shape of the cell is preferably square shape or polygonal shape having sides and corners with small roundness (radius of curvature). Further as shape of a cell arranged usually within a chip in nearly square shape, similar shape to the chip is excellent. The concrete cell arrangement structure of the present invention will be described based on the square cell as follows.

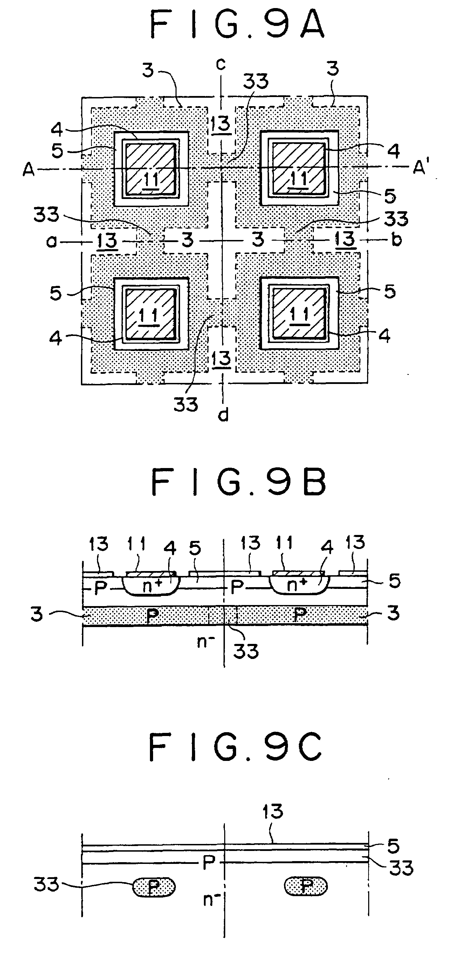

Figs. 9A, 9B and 9C show another embodiment of two-dimensional layout of unit cells. Fig. 9A is a front surface view of a semiconductor substrate, Fig. 9B is a sectional view at a position of line AA', and Fig. 9C is a sectional view at a position of line ab. Constituent parts in Figs. 9A, 9B and 9C designated by the same reference numerals as those in Figs. 8A and 8B indicate the parts equivalent in structure, conduction type and function. This embodiment is different from the embodiment in Figs. 8A and 8B in that extended parts 33 of second gate regions 3 are provided to couple the second gate regions 3 of individual cells. Although not shown in Figs. 9A, 9B and 9C, the second gate regions are coupled electrically and a second gate electrode is connected to the second gate region by low resistance. As above described, the potential of the second gate electrode is made the same potential as that of the n⁺-type source region 4 or the same potential as that of the gate region 5 being the first gate region, and can be controlled in the ON/OFF control. In order that decrease in the area of the longitudinal channel part being a current passage at the ON state is made minimum and the second gate regions are coupled, in this embodiment, coupling parts are provided in the four sides of the square cell. Of course, the coupling parts need not be provided in all four sides, but may be provided only in one to three sides.

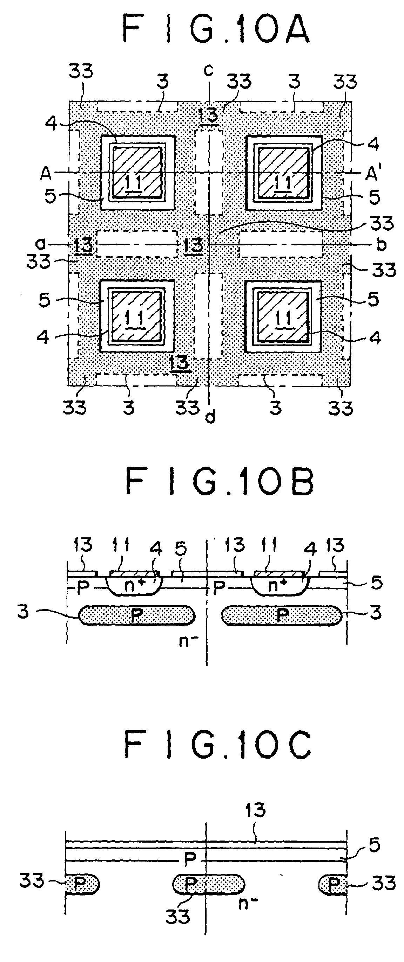

Figs. 10A, 10B and 10C shows still another embodiment of two-dimensional layout of unit cells. Fig. 10A is a front surface view of a semiconductor substrate, Fig. 10B is a sectional view at a position of line AA', and Fig. 10C is a sectional view at a position of line ab. Constituent parts in Figs. 10A, 10B and 10C designated by the same reference numerals as those in Figs. 9A, 9B and 9C indicate the parts equivalent in structure, conduction type and function. This embodiment is characterized in that the coupling parts 33 of the second gate regions 3 are provided at four corners of the square cell. In a part where cells are arranged in cross (in Fig. 10A, a part where lines ab and cd intersect orthogonally), the width Wvch of the longitudinal channel part becomes wide. Thus the pinch-off becomes insufficient there, and the voltage OFF characteristics at the high voltage may be deteriorated. In this embodiment, the part with the cells arranged in cross becomes the coupling part. Thus this embodiment is more excellent than the embodiment shown in Figs. 9A, 9B and 9C where the coupling is performed at the side parts of the square cell in that the deterioration of the OFF characteristics can be prevented. Of course, even in this embodiment, if the width Wvch of the longitudinal channel part is set narrow in the range of not deteriorating the OFF characteristics, the coupling parts need not be provided in all four corners but may be provided only in one to three corners.

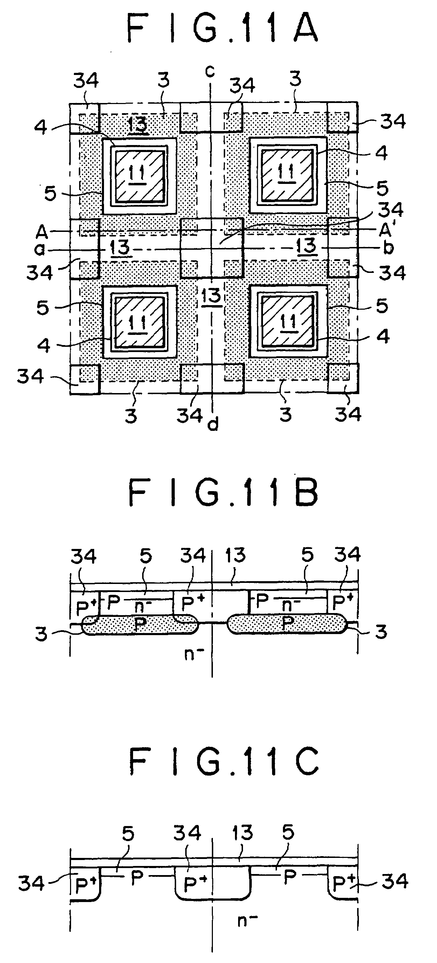

Figs. 11A, 11B and 11C show an embodiment showing other coupling means of the second gate region of unit cells. Fig. 11A is a front surface view of a semiconductor substrate, Fig. 11B is a sectional view at a position of line AA', and Fig. 11C is a sectional view at a position of line ab. Constituent parts in Figs. 11A, 11B and 11C designated by the same reference numerals as those in Figs. 8A and 8B indicate the parts equivalent in structure, conduction type and function. At the corners of the square cell, p-type layers 34 are provided in a portion where it extends through, from one main surface of the semiconductor substrate, the first p-type gate region 5 and reaches the second gate region 3. The second gate regions 3 of unit cells are coupled by the p-type layers 34, and further the second gate region 3 is electrically coupled with the first p-type gate region 5. Thus there is an advantage in that the gate control to make the two gate regions the same potential becomes possible without providing a second gate electrode newly. This embodiment shows an example that the p-type layers 34 are provided in all corners of the square cell, the intended function can be obtained even when the p-type layers 34 are provided in a part of the corners of the square cell. Also when there are the coupling parts 33 of the second gate regions 3 at the sides and the corners of the square cell as shown in Figs. 9 and 10, the p-type layers 34 can be applied as the connecting means of the first gate region and the second gate region.

The embodiment relating to the cell arrangement has been described regarding the cell of square shape, but, of course, it can be applied also in the cell structure of rectangular shape and polygonal shape.

The embodiment relating to the cell arrangement has been described in the embodiment of Fig. 1 regarding the basic cell of the present invention, but, of course, such arrangement of a plurality of cells can be applied also to the cell structure shown in other embodiments of the present invention as above described.

According to the individual embodiments as above described, the static induction transistor of SiC can be realized which is excellent in the OFF characteristics and capable of being manufactured easily.

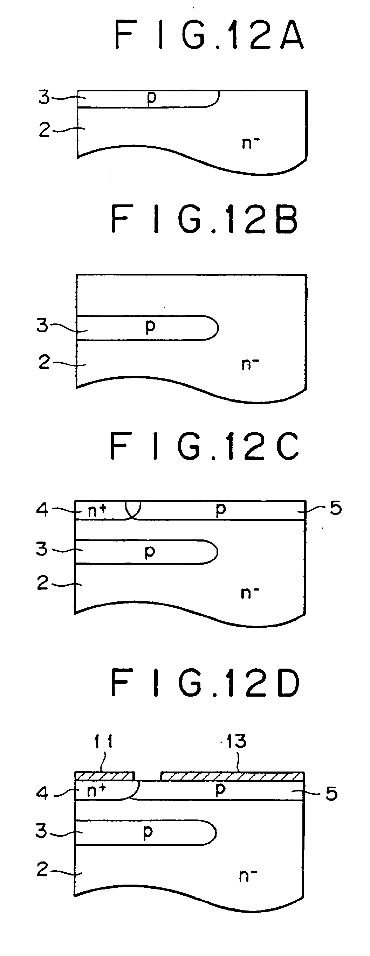

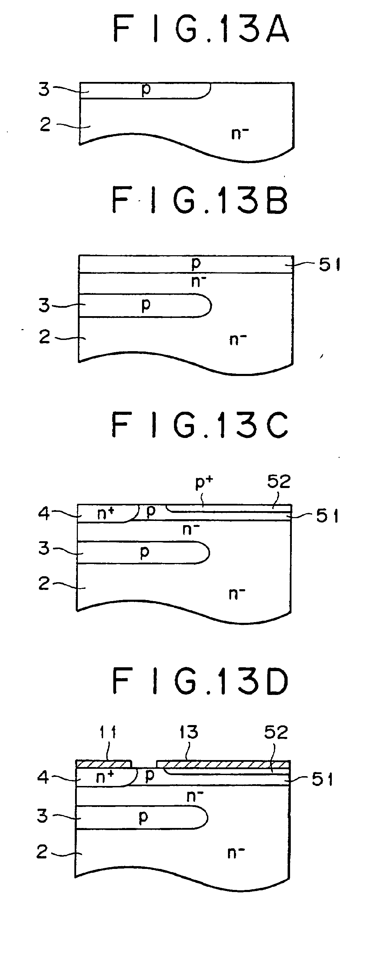

Figs. 12A to 12D show a part of process of fabricating a static induction transistor of SiC in the first embodiment. Ion implantation of aluminum or boron is performed from a surface of an n⁻-type region 2 of a semiconductor substrate of SiC using a resist (not shown, and so forth) as a mask. Thus (Fig. 12A) a p-type region 3 is formed, and (Fig. 12B) the n⁻-type region 2 is laminated and grown by the epitaxial method. Next, (Fig. 13C) using a resist as a mask, ion implantation of nitrogen is performed to form an n⁺-type region 4, and ion implantation of aluminum or boron is performed, whereby a p-type region 5 is formed so that both regions come in contact with each other. Thereafter a source electrode 11, a drain electrode 12 and a gate electrode 13 are formed. Thus an element is completed.

Figs. 13A to 13D show a part of process of fabricating a static induction transistor of SiC in the second embodiment. Ion implantation of aluminum or boron is performed from a surface of an n⁻-type region 2 of a semiconductor substrate of SiC using a resist as a mask. Thus (Fig. 13A) a p-type region 3 serving as a second gate region is formed, and (Fig. 13B) the n⁻-type region 2 is grown by the epitaxial method and further a p-type region 51 serving as a first gate region is laminated on the n⁻-type region 2. Next, using a resist as a mask, ion implantation of nitrogen is performed to form an n⁺-type region 4. Further, (Fig. 13C) using a resist as a mask, ion implantation of boron preferably aluminum is performed, whereby a p⁺-type region 52 is formed. Thereafter a source electrode 11, a drain electrode 12 and a gate electrode 13 are formed. Thus an element is completed.

Since the p-type region 51 is formed by the epitaxial growth, in comparison with the manufacturing method shown in Figs. 9A, 9B and 9C where any of the n⁺-type region 4 and the p-type region 5 is formed by the ion implantation, a problem of increase of a leak current of the gate^{.}source junction due to the crystal defect remaining in the overlapped portion of the ion implantation layers can be avoided, and the junction excellent in the blocking characteristics can be obtained.

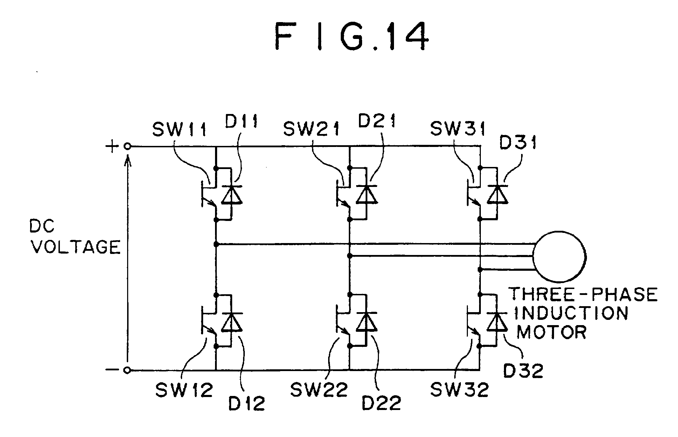

Fig. 14 shows an example of constitution of an inverter device for driving a three-phase induction motor using static induction transistors of SiC to which the present invention is applied and diodes connected to the transistors in inverse-parallel connection. The six static induction transistors SW11, SW12, SW21, SW22, SW31, SW32 are turned on or off such that the DC power is converted into the AC power and the three-phase induction motor is driven. The static induction transistor of SiC according to the present invention has little loss, and a cooling system therefor can be simplified. That is, low cost and high efficiency of the system using the inverter device can be attained.

The embodiments of the present invention have been described, but the present invention covers further more application areas or derivative areas.

In the individual embodiments as above described, a semiconductor material for the semiconductor substrate is SiC but also another semiconductor material can be applied. Particularly a wide gap semiconductor material, such as diamond or gallium nitride, with large energy band gap than that of Si is effective.

The present invention can be applied also to a static induction transistor of SiC where the conduction type of each region is inverted in each embodiment as above-described.

According to the present invention as above-described, static induction transistors of SiC being excellent in the ON characteristics can be realized without difficulty in the process.

## Claims

1. A static induction transistor comprising:
a semiconductor substrate with an energy band gap greater than that of silicon, having
a first semiconductor region of a first conduction type,
a second semiconductor region of a first conduction type, positioned on the surface of said first semiconductor region and having an impurity concentration higher than that of said first semiconductor region,
a first gate region of a second conduction type positioned on the surface of said first semiconductor region, and
a second gate region of a second conduction type, including the projection of said second semiconductor region and partially including the projection of said first gate region within said first semiconductor region;
a drain electrode connected electrically to said first semiconductor region;
a source electrode connected electrically to said second semiconductor region; and
a gate electrode connected electrically to said first gate region;
characterized in that said second semiconductor region and said first gate region are in contact with each other on the surface of said first semiconductor region.

2. A static induction transistor as set forth in claim 1, wherein at the blocking state of the static induction transistor, the potential of the second gate region is in the floating state, or in the same potential as that of said second semiconductor region or the same potential as that of said first gate region.

3. A static induction transistor as set forth in claim 1, wherein the length of a part, in said second gate region, overlapping the projection of said second semiconductor region is larger than the width of a part of said first semiconductor region disposed between said first gate region and said second gate region.

4. A static induction transistor as set forth in claim 1, wherein said first gate region has a first part being in contact with said second semiconductor region, and a second part having an impurity concentration higher than that of said first part and being in contact with said gate electrode.

5. A static induction transistor as set forth in claim 1, further comprising an embedded region of a second conduction type separated from said second gate region within said first semiconductor region.

6. A static induction transistor as set forth in claim 1, wherein a semiconductor material of said semiconductor substrate is selected among silicon carbide, diamond and gallium nitride.

7. A static induction transistor comprising:
a semiconductor substrate with an energy band gap greater than that of silicon, having
a first semiconductor region of a first conduction type,
a second semiconductor region of a first conduction type, positioned on the surface of said first semiconductor region and having an impurity concentration higher than that of said first semiconductor region, and
a gate region of a second conduction type including the projection of said second semiconductor region within said first semiconductor region;
a drain electrode connected electrically to said first semiconductor region;
a source electrode connected electrically to said second semiconductor region; and
a gate electrode connected electrically to the surface of said first semiconductor region;
characterized in that said first semiconductor region and said gate electrode form a Schottky junction.

8. A static induction transistor as set forth in claim 7, wherein a plurality of said second gate regions are coupled with each other by semiconductor layers of a second conduction type.

9. A static induction transistor as set forth in claim 8, wherein said semiconductor layers are extended portions of said second gate regions.

10. A static induction transistor as set forth in claim 8, wherein said semiconductor layer extends through said first gate region and reaches said second gate region.

11. A method of manufacturing a static induction transistor, comprising the steps of:
forming a second gate region of a second conduction type on a surface of a first semiconductor region of a first conduction type of a semiconductor substrate with an energy band gap greater than that of silicon;
growing said first semiconductor region onto said first semiconductor region and said second gate region by the epitaxial method; and
forming a first gate region of a second conduction type onto said first semiconductor region after growing by the epitaxial method.

12. An electric power conversion apparatus in which a static induction transistor is turned on or off and thereby electric power is converted,
said static induction transistor comprising:
a semiconductor substrate with an energy band gap greater than that of silicon, having
a first semiconductor region of a first conduction type,
a second semiconductor region of a first conduction type, positioned on the surface of said first semiconductor region and having an impurity concentration higher than that of said first semiconductor region,
a first gate region of a second conduction type positioned on the surface of said first semiconductor region, and
a second gate region of a second conduction type, including the projection of said second semiconductor region and partially including the projection of said first gate region within said first semiconductor region;
a drain electrode connected electrically to said first semiconductor region;
a source electrode connected electrically to said second semiconductor region; and
a gate electrode connected electrically to said first gate region;
characterized in that on the surface of said first semiconductor region, said second semiconductor region and said second semiconductor region are in contact with each other.

13. An electric power conversion apparatus in which a static induction transistor is turned on or off and thereby electric power is converted,
said static induction transistor comprising:
a semiconductor substrate with an energy band gap greater than that of silicon,
having a first semiconductor region of a first conduction type,
a second semiconductor region of a first conduction type, positioned on the surface of said first semiconductor region and having an impurity concentration higher than that of said first semiconductor region, and
a gate region of a second conduction type including the projection of said second semiconductor region within said first semiconductor region;
a drain electrode connected electrically to said first semiconductor region;
a source electrode connected electrically to said second semiconductor region; and
a gate electrode connected electrically to the surface of said first semiconductor region;
characterized in that said first semiconductor region and said gate electrode form a Schottky junction.
